# EUROPEAN PATENT SPECIFICATION

(11) **EP 4 338 558 B1**
(45) Date of publication and mention of the grant of the patent: **11.12.2024**
(21) Application number: 22726082.5
(22) Date of filing: 28.04.2022
(51) Int. Cl.: H05K 5/00, H05B 47/19

(54) **SECURE LOCKING OF ENCLOSURE ELEMENT OF A COMMUNICATION ELEMENT**
SICHERE VERRIEGELUNG EINES GEHÄUSEELEMENTS EINES KOMMUNIKATIONSELEMENTS
VERROUILLAGE SÉCURISÉ DE L'ÉLÉMENT DE FERMETURE D'UN ÉLÉMENT DE COMMUNICATION

(30) Priority: 11.05.2021 EP 21173380
(43) Date of publication of application: 20.03.2024
(73) Proprietor: Signify Holding B.V., 5656 AE Eindhoven (NL)
(72) Inventor: VAN OS, Petrus, Johannes, Maria, 5656 AE Eindhoven (NL)
(74) Representative: Verweij, Petronella Daniëlle
(86) International application number: PCT/EP2022/061315
(87) International publication number: WO 2022/238130

(56) References cited:
- US-A1- 2017 125 882

## Description

### FIELD OF THE INVENTION

The invention relates to a lighting device control assembly comprising a communication element comprising an enclosure element. The invention further relates to a light generating module comprising a lighting device control assembly. The invention also relates to method for assembling a lighting device control assembly.

### BACKGROUND OF THE INVENTION

Enclosure elements of communication elements are known in the art. US2017/125882, for instance, describes a wirelessly programmable electronic control gear, which may include an essentially enclosed metal or metallized housing. The housing is a punched and curved sheet-metal housing. The wirelessly programmable electronic control gear may further include a circuit board with an antenna component fitted thereon to receive wireless programming signals, and an area in the metal or metallized housing which has at least one longitudinal recess. The at least one recess is located close to the antenna. The orientation of the longitudinal recess is designed as essentially parallel to magnetic field lines of the antenna. This document also describes that in a conventional solution to the problem, an antenna is disposed outside the housing alongside the terminal block, so that the wireless programming signals can be received. This solution circumvents the problem of the metal housing, since the antenna is disposed at this position outside the housing together with the terminals on a circuit board. A disadvantage here is that valuable space for the terminals is used and the layout of the circuit board becomes unnecessarily complicated, as there is little space on the circuit board surface at this position, since prescribed air gaps and leakage paths must be maintained. Furthermore, the processing logic is disposed further inside the device, resulting in long conductor paths to the antenna and the programming is quite susceptible to interference due to these long conductor paths.

US 2017/125882 A1 discloses various embodiments providing a wirelessly programmable electronic control gear, which may include an essentially enclosed metal or metallized housing. The housing is a punched and curved sheet-metal housing. The wirelessly programmable electronic control gear may further include a circuit board with an antenna component fitted thereon to receive wireless programming signals, and an area in the metal or metallized housing which has at least one longitudinal recess. The at least one recess is located close to the antenna. The orientation of the longitudinal recess is designed as essentially parallel to magnetic field lines of the antenna

### SUMMARY OF THE INVENTION

In or for drivers NFC (Near Field Communication) antennas and wireless modules may be used. The NFC antennas and wireless modules may be configured on a PCB (module) which may be mounted on a main driver PCB. As those PCB modules may be potential unsafe, those antennas and modules may be protected by a cover over. When such cover is clicked in the driver main PCB, there may be a potential safety risk as the cover can come loose.

Hence, it is an aspect of the invention to provide an alternative enclosure element which preferably further at least partly obviates one or more of above-described drawbacks. The present invention may have as object to overcome or ameliorate at least one of the disadvantages of the prior art, or to provide a useful alternative.

In a first aspect, the invention provides a device control assembly ("assembly"), such as in embodiments a lighting device control assembly. The device control assembly may comprise a housing part and a support. The support may comprise a printed circuit board. Especially, the support may comprise a first support part and a second support part. In embodiments, the support may be functionally coupled to the housing part. Further, the assembly may comprise device control electronics, such as in embodiments lighting device control electronics. The device control electronics are especially functionally coupled to the first support part of the support. Further, the assembly may comprise a closure, in specific embodiments a metal closure, which may be functionally coupled to the housing part. In embodiments, the device electronics, especially the lighting device control electronics, may be configured in an enclosure at least partly defined by the closure, especially the metal closure, and the housing part. Further, the assembly may comprise a communication element. Especially, the communication element may be functionally coupled to the second support part and may be functionally coupled to the device control electronics, such as in embodiments lighting device control electronics. Further, the assembly may comprise an enclosure element, in specific embodiments a polymeric enclosure element. The enclosure element may especially be functionally coupled to the second support part. Further, in embodiments the enclosure element, especially the polymeric enclosure element, may at least partly encloses the communication element. Further, in specific embodiments the enclosure element, more especially the polymeric enclosure element, may comprise an enclosure extension, especially a first polymeric enclosure extension. Yet, in specific embodiments the closure, especially the metal closure, may be configured to lock the enclosure extension, more especially the first polymeric enclosure extension. Hence, in specific embodiments the invention provides a lighting device control assembly comprising: (a) a housing part; (b) a support comprising a printed circuit board, wherein the support comprises a first support part and a second support part; wherein the support is functionally coupled to the housing part; (c) lighting device control electronics functionally coupled to the first support part of the support; (d) a metal closure functionally coupled to the housing part, wherein the lighting device control electronics are configured in an enclosure at least partly defined by the metal closure and the housing part; (e) a communication element functionally coupled to the second support part and functionally coupled to the lighting device control electronics; and (f) a polymeric enclosure element functionally coupled to the second support part, wherein the polymeric enclosure element at least partly encloses the communication element, wherein the polymeric enclosure element comprises a first polymeric enclosure extension, wherein the metal closure is configured to lock the first polymeric enclosure extension.

With such enclosure it may be possible to safely house the communication element(s). The housing of the communication element may be associated with the support and may be locked by the closure, such that removal of the housing may essentially be impossible, without breaking the housing and/or without removing the closure. Further, the way in which the communication element may be comprised by the assembly may still allow good receipt and/or sending of signals. Such a device may be more safe as the enclosure may not detach unintentionally. Further, as bosses of the closure do not need to (partially) melt and/or deform in a solder bath, there may be many more suitable options for the polymeric material. Also, as the bosses do not necessarily deform in the solder bath, the closure may be provided in a detachable fashion.

As indicated above, the device control assembly may especially comprise a lighting device control assembly. Especially, the invention will be explained in relation to a lighting application.

The assembly may comprise a housing part and a closure. Especially, the housing part and the closure may together form an enclosure ("primary enclosure"). Especially, the closure may be attached to the housing part via connection means like click connections. In this way, the closure may be fixated to the housing part, and may only be removable when pressing or deforming a click element, such that the closure can be slide from the housing part in an opposite direction as the closure was assembled on the housing part. Instead of the term "closure" also the term "cover" may be applied.

Herein, click connections are mentioned as embodiments of connection means. Alternatively or additional connection means may be screw connections, gluing connections, wilding connections, and/or riveting connections. Especially, herein click connections may be applied.

In embodiments, the closure may especially comprise copper, steel, or aluminum. Especially, steel may be applied.

Hence, the closure may be functionally coupled to the housing part. Herein, the term "functionally coupled" may in embodiments refer to a physical connection or mechanical connection between at least two elements, such as via one or more of a screw, a solder, an adhesive, a melt connection, a click connection, etc. The terms "physical connection" and "mechanical connection" may herein interchangeably be used. The terms "physical connection" and "mechanical connection" may thus also refer to an adhesive connection. Especially, the closure may be mechanically coupled to the housing part, more especially via a click connection.

The "term housing part" is used as the housing part and the closure may form a housing, especially for the device control electronics. In embodiments, the housing part may especially comprise copper, steel, or aluminum. Especially, steel may be applied.

Further, in embodiments the housing part may have a larger length than the closure, as the communication element may be configured external from the enclosure, but may be functionally coupled to the housing part (directly or via a support, see further also below). For instance, in embodiments the housing part may in embodiments be in the range of 1-15 cm longer than the closure, such as in specific embodiments about 2-10 cm. Both the closure and the housing part may be elongated, with in embodiments having a length which is at least twice as long as the height and/or at least twice as long as the width of the enclosure provided by the housing part and the closure.

The housing part may be configured to be associated with the closure and the closure may be configured to be associated with the housing part. Further, the housing part may be configured to support the support. The support may be associated to the housing part with connection means like one or more of click connections and screws, though other options may also be possible (see also above). In specific embodiments, the support may be clamped between the housing and the closure.

Hence, the support may be functionally coupled to the housing part. Especially, the support many be mechanically coupled to the housing part, more especially via one or more of click connections and screws.

Hence, in embodiments both the first support part and the second support part may be supported by the housing part.

Especially, the support may comprise a printed circuit board.

The printed circuit board may especially be configured electrically isolated from the housing part. This is known to a person skilled in the art. In specific embodiments a an electrically insulating material, such as an electrically insulating foil, may be used to electrically isolate the printed circuit board from the housing part.

As can be derived from the below, in embodiments the electrical conductivity of the electrically insulating material, such as an electrically insulating foil, may in embodiments especially be equal to or smaller than 1·10⁻¹⁰ S/m, especially equal to or smaller than 1·10⁻¹³ S/m.

As known in the art, a printed circuit board ("PCB" or "board") may mechanically support and electrically connect electronic components or electrical components using conductive tracks, pads and other features etched from one or more sheet layers of copper laminated onto and/or between sheet layers of a non-conductive substrate (shortly indicated as "track" or "conductive track").

Hence, in embodiments a PCB may comprise an insulating layer arranged between a substrate and a conductive layer.

An (electronic) component, such as a solid stage light source, may generally be soldered onto the PCB to both electrically connect and mechanically fasten it to the PCB. For instance, a basic PCB may consist of a flat sheet of insulating material and a layer of copper foil, laminated to the substrate. Chemical etching divides the copper into separate conducting lines called tracks or circuit traces, pads for connections, vias to pass connections between layers of copper, and features such as solid conductive areas for EM shielding or other purposes. The tracks function as wires fixed in place, and are insulated from each other by air and the board substrate material. The surface of a PCB may have a coating that protects the copper from corrosion and reduces the chances of solder shorts between traces or undesired electrical contact with stray bare wires. For its function in helping to prevent solder shorts, the coating is called solder resist.

Hence, the shape of a PCB may in general be plate-like. Especially, in embodiments the PCB may have a length and a width and a height, wherein an aspect ratio of the length and the height is at least 5, like in the range of 5-5000, like 10-2500, and an aspect ratio of the width and the height is at least 2, such as an aspect ratio of at least 5, like in the range of 5-5000, like 10-2500. The terms "length", "width", and "height" may also refer to "largest length", "largest width", and "largest height", respectively. The PCB may especially have a rectangular cross-section (such as a square cross-section).

The height (or thickness) of the PCB may in embodiments be selected from the range of 0.2-10 mm, such as 0.5-5 mm, like 1-2 mm. The width of the PCB may in embodiments be selected from the range of 5-200 mm, such as 5-50 mm. The length of a single printed circuit board area may in embodiments e.g. be selected from the range of 10-50 mm, such as 15-40 mm. The length of the PCB, including a plurality of (connected) PCB areas, may in embodiments e.g. be selected from the range of 20-2000 mm, such as 20-1500 mm. Other dimensions may be possible as well.

In further embodiments, the functional component may comprise an electronic component, especially an electronic component selected from the group comprising a solid state light source, a driver, an electronic module, or a sensor.

In embodiments, the board may comprise a rigid board or a semi-rigid board, especially a rigid board. In other embodiments, the board may comprise a semi-rigid board.

In embodiments, the board may comprise a metal, especially a metal selected from the group comprising copper aluminum, tin, iron, silver and lead, more especially a metal selected from the group comprising copper and aluminum.

In further embodiments, the (printed circuit) board may have a thermal conductivity of at least 200 W/(m*K), especially at least 250 W/(m*K), such as at least 300 W/(m*K).

In specific embodiments, the board may comprise a printed circuit board. Especially, the board may comprise one or more of a CEM-1 PCE, a CEM-3 PCE, a FR-1 PCE, a FR-2 PCB, a FR-3 PCB, a FR-4 PCB, and aluminum metal core PCB, especially one or more of a CEM-1 PCB, a CEM-3 PCB, a FR-1 PCB, and a FR4 PCB and an aluminum metal core PCB, more especially one or more of a CEM-1 PCB, a CEM-3 PCB, a FR-1 PCB.

In embodiments, the support comprises a first support part and a second support part. As indicated above, the support is functionally coupled to the housing part. The first support part and the second support part may form a monolithic support (or may thus be parts of a monolithic support, such as a (monolithic) PCB). Hence, especially the terms "first support part" and "second support part" may refer to respective parts of a PCB.

The device control assembly may further comprise electronics, which may especially be functionally coupled to the first support part of the support.

The term "functionally coupled" may in embodiments refer to an electrical conductive connection between at least two connections. When two (or more) elements have an electrical conductive connection, then there may be a conductivity (at room temperature) between the two (or more) elements of at least 1·10⁵ S/m, such as at least 1·10⁶ S/m. In general, an electrically conductive connection will be between two (or more) elements each comprising an electrically conductive material, which may be in physical contact with each other or between which an electrically conductive material is configured. Herein a conductivity of an insulated material may especially be equal to or smaller than 1·10⁻¹⁰ S/m, especially equal to or smaller than 1·10⁻¹³ S/m. Herein a ratio of an electrical conductivity of an isolating material (insulator) and an electrical conductivity of an electrically conductive material (conductor) may especially be selected smaller than 1·10⁻¹⁵. Here, the functional coupling of the electronics and the first support part may be a mechanical coupling and an electrical coupling ("electrically conductive connection"), as the (first) support (part) may comprise electrically conductive tracks with which the device electronics may be functionally coupled.

The device control electronics may be functionally coupled with an electronic device (or electronic component) external from the assembly.

Especially, the device control electronics may comprise lighting device control electronics. Hence, the device control assembly may comprise a lighting device control assembly and the device control electronics may comprise lighting device control electronics.

As indicated above, especially the (metal) closure may functionally be coupled to the housing part, such as via a click connection. In this way an enclosure may be formed. Especially, the (lighting) device electronics may be configured in an enclosure. The enclosure may (thus) at least partly defined by the (metal) closure and the housing part.

The above combination of the closure, housing part, and device electronics, may in embodiments essentially be the same as driver assemblies known in the art, however, at least except for the fact that part of the housing part extends beyond the closure, and at least except for the fact that the closure has a locking function, in addition to a closing function. As will further be explained below, the closure may be used to lock an element functionally coupled to the second support part, external from the enclosure (which may also be different from driver assemblies known in the art). Further, the assembly may differ in embodiments from a number of prior art assemblies in that a communication element is available, such as in specific embodiments a communication element at least partly enclosed in a separate enclosure.

Hence, as indicated above the assembly may further comprise a communication element functionally coupled to the second support part and functionally coupled to the (lighting) device control electronics. Here, the functional coupling of the communication element and the second support part may be a mechanical coupling and an electrical coupling ("electrically conductive connection"), as the (second) support (part) may comprise electrically conductive tracks with which the communication element may be functionally coupled. Further, the functional coupling of the communication element and the (lighting) device control electronics may be an electrical coupling ("electrically conductive connection"), as the (second) support (part) may comprise electrically conductive tracks with which the communication element may be functionally coupled. Alternatively or additionally, the functional coupling of the communication element and the (lighting) device control electronics may also comprise a coupling via wireless communication, such a via Wi-Fi or Bluetooth or LiFi, etc.

In specific embodiments, the communication element may be selected from the group consisting of a near field communication antenna and a wireless communication device.

Especially, the communication element may at least partially enclosed by a cover or enclosure element. The enclosure element may protect the communication element and/or may protect users from touching the communication element (and its electronics), which could potentially be dangerous (in embodiments). Hence, the assembly may further comprise an enclosure element, more especially a polymeric enclosure element. Especially, the enclosure element is functionally coupled to the second support part. Here, the functional coupling of the enclosure element and the second support part may be a mechanical coupling, such as via click elements, bosses, etc. (see also below).

Further, the (polymeric) enclosure element may at least partly enclose the communication element. The (polymeric) enclosure element may comprise a first (polymeric) enclosure extension. Hence, a housing part of enclosure element and the enclosure extension of the enclosure element may be a monolithic body, such as e.g. be obtained by polymer casting, molding, etc.

The enclosure element and the support may provide a secondary enclosure, wherein the communication element may be configured.

In embodiments, the enclosure element may essentially entirely enclose the communication element, except for an opening part directed to the support element. The opening part may essentially be closed by the support element.

Especially, the closure - in a functional coupling with the housing part - may be configured such that the enclosure extension may be essentially locked, whereby also the enclosure element as such may (thus) be locked. Especially, even though the enclosure element is external from the enclosure defined by the housing part and the closure, the closure may be configured such that a movement of the enclosure element in a direction away from the second support part may essentially be prevented. Hence, in specific embodiments the (metal) closure may be configured to lock the first (polymeric) enclosure extension. Hence, in embodiments the (metal) closure may effectively be configured to lock the first (polymeric) enclosure.

The configuration of the closure relative to the enclosure extension may in embodiments be selected from a clearance fit, a location fit, and an interference fit. Especially, the configuration of the closure relative to the enclosure extension may in embodiments be such that a translational freedom in at least two perpendicular directions may be at maximum about 1 mm, such as selected from the range of 0-0.5 mm. For instance, assuming the support to be elongated, a translation in a direction parallel to an axis of elongation may be at maximum about 1 mm and a translation in a direction perpendicular to the support may also be at maximum about 1 mm. Especially, a translation in a direction perpendicular to these directions, i.e. parallel to a width of the support may also be small, such as at maximum about 1 mm, but this (substantially immobility in the direction parallel to the width of the support) may in embodiments be due to one or more of (a) the configuration of the closure relative to the enclosure extension, and (b) the configuration of the (polymeric) enclosure element relative to the communication element. The (polymeric) enclosure element may in specific embodiments essentially only be movable in a direction perpendicular to the support, thereby substantially preventing the (polymeric) enclosure element and the enclosure extension to move in other directions.

Further, in specific embodiments the metal closure may be configured to exert a force on the first polymeric enclosure extension in a direction of the support.

As indicated above, the enclosure may host device control electronics, especially lighting device control electronics. In specific embodiments, the lighting device control electronics may comprise a lighting device driver. Alternatively or additionally, the (lighting) device control electronics may comprise other electrical devices that may be functionally coupled to an NFC and/or a wireless communication device. A driver may be used to control e.g. a dimming level of light from a lighting device. A driver may be used to control e.g. one or more of a color point and correlated color temperature of light from a lighting device. The driver may e.g. operate in dependence of a sensor, see also below.

A substantial part of the communication element may be enclosed by the (polymeric) enclosure element. In embodiments, the polymeric enclosure element encloses at least 50% ("enclosing percentage") of the communication element, such as at least about 60%, like even more especially at least about 70%. The percentage of enclosure can be defined by using the smallest cuboid enclosing the enclosure element and the communication element, and integrating the are from which a normal of the cuboid intersects the enclosure element. In general, the enclosing percentage is lower than 100%, as there may be substantially no enclosure element material between the communication element and the support. In specific embodiments, the enclosure element defines a cavity having an essentially cuboid shape and having dimensions essentially the same as the smallest cuboid enclosing the communication element. Therefore, in embodiments the polymeric enclosure element encloses at least 50%, such as at least 60%, like especially at least about 70% of an external surface of the communication element.

The (polymeric) enclosure element may especially have the function of enclosing at least part of the communication element. The first (polymeric) enclosure extension, which is associated to the enclosure element, may especially have as function to be locked by the closure and/or to facilitate locking of the enclosure element by the closure. Hence, the phrase "the metal closure is configured to lock the first polymeric enclosure extension", and similar phrases, may especially (effectively) indicate that the metal closure is configured to lock the enclosure element. As indicated above, the locking may essentially prevention movement in one or more directions.

Hence, the enclosure element may comprise a part that provides a housing and a part ((polymeric) extension) that may be used to lock the enclosure element.

Especially, the first polymeric enclosure extension may comprises a notch element. Part of the closure may be configured in the notch. This may prevent substantial movement at least in two opposite directions. Optionally, the closure element may exert a force on an edge of the notch element in the direction of the support. Note that the term "notch" may also refer to a plurality of notches. In embodiments, the notch may be a rectangular cavity. In other embodiments, the notch may have a (cross-sectional) curved cavity. In yet other embodiments, the notch may have a non-rectangular (cross-sectional) shape. When using two or more notches and/or when using a non-rectangular (cross-sectional) shape of the notch(es), the locking function may be enhanced. For instance, it may be possible to prevent essentially any movement at least in a plane parallel to the support. Further, the closure may essentially prevent a movement of the enclosure element in a direction perpendicular to the support (and away from the support).

Hence, in embodiments part of the closure and the notch may have a male-female configuration (i.e. may be configured in a male-female configuration).

The enclosure extension and the closure may also provide a click connection. For instance, the closure may comprise a part that enters the notch and which has an opening for a click element from the enclosure extension. Also this may further improve the locking function.

Alternatively or additionally, the (polymeric) enclosure element may comprise two or more (in specific embodiments parallel configured) first (polymeric) enclosure extensions, each comprising a notch element. Also this may further improve the locking function. The first (polymeric) enclosure extensions may further have a mutual connection, like a bridging element, which may increase strength of the first (polymeric) enclosure extensions. In specific embodiments, the bridging element may comprise the notch, or may comprise an additional notch (see further also below).

Relative to the support and the housing part of the enclosure element, the first extension may have a shape extending in a direction parallel to the support, and the second extension may have a shape extending in a direction perpendicular to the support.

The support element, especially the PCB, may comprise openings wherein extensions of the (polymeric) enclosure element may be hosted. This may further provide a locking function, especially in a direction parallel to the support. When using click element, the (polymeric) enclosure element may also be substantially locked in direction perpendicular to the support. Hence, in embodiments the support may comprise one or more support part openings, wherein the polymeric enclosure element comprises one or more second polymeric enclosure extensions extending into the one or more support part openings. Further, in specific embodiments the one or more second polymeric enclosure extensions are selected from the group of (i) bosses and (ii) click connection elements configured for a click connection with the respective support part openings.

During production of the control assembly, the backside (or "second side") of the PCB, i.e. the side opposite of the side where the communication element is configured, may be exposed to a solder bath. It may be that second extensions, which may optionally extend from the backside, may be deformed during exposure to the solder bath. For instance, a boss or a click connection may deform when contacted with the solder bath. Hence, in specific embodiments the one or more second polymeric enclosure extensions may comprise at least one click connection element, wherein a part of the click connection element at a second side of the support other than a first side of the communication element is at least partly deformed (especially as a result of exposure to a solder bath).

Without the locking function provided by the enclosure extension and the closure, it may be desirable that the enclosure element comprises a polymeric material that may essentially withstand the high temperature of the solder bath. With the present invention, this condition is less necessary or not necessary at all. Hence, the freedom in choosing (polymeric) materials is larger. In specific embodiments, the polymeric enclosure element may comprises polycarbonate (PC). Alternatively or additionally to polycarbonate, e.g. one or more of polyphenylene sulfide (PPS) or polyether ether ketone (PEEK) may be applied, or even other materials like e.g. Noryl type polymers. However, especially in the present invention PC may be applied.

Especially, the entire enclosure element comprises the same material, i.e. the housing part and the enclosure extension comprise the same material, such as polycarbonate. As indicated above, the enclosure extension may be a monolithic body.

The enclosure element may be of a material that is electrically insulating. As can be derived from the above, in embodiments the electrical conductivity of the material of the enclosure element may in embodiments especially be equal to or smaller than 1·10⁻¹⁰ S/m, especially equal to or smaller than 1·10⁻¹³ S/m.

The closure may comprise a first closure part configured parallel to a length axis (LA) of the support and providing a top wall of the enclosure. Hence, the top wall may in specific embodiments be parallel configured the support.

Further, the closure may comprise a second closure part providing a side wall of the enclosure. Such side wall may in embodiments be substantially planar or may in other embodiments be curved. Especially, a part of the side wall may be planar. More especially, the sidewall may be substantially planar. The second closure part may in embodiments be configured substantially perpendicular to the support.

Especially, the first closure part and the second closure part may be a monolithic body, like e.g. a molded, folded, or drawn element. In specific embodiments, the closure may be sheet metal. In further embodiments, the closure may be stamped, laser cut, or water cut.

The term "second part" may also refer to a plurality of second parts. For instance, the first closure part may have a rectangular shape with four second closure part extending there from. When there are more than one side wall, herein the term "the side wall" may especially refer to the one of the side walls that may provide the locking function of the enclosure. In embodiments, the closure may essentially have a shape of an open cuboid, especially an open elongated cuboid, with five faces, of which four extend from the other of the five faces. In specific embodiments, all of these faces may configured essentially parallel to the length axis, and one of the faces may be configured essentially parallel to the support.

Hence, in specific embodiments the (metal) closure may comprise (i) a first closure part configured parallel to a length axis (LA) of the support and providing a top wall of the enclosure, and (ii) a second closure part providing a side wall of the enclosure. Especially, the second closure part may be configured to lock the first (polymeric) enclosure extension. In yet further specific embodiments, the second closure part is configured to exert the force on the first polymeric enclosure extension in the direction of the support.

In specific embodiments, the side wall may be shape such that e.g. two or more parts may be configured in two or more notches. This may further facilitate the locking of the enclosure element. For instance, the side wall may have a kind of folding structure, with at least two extensions. Hence, in specific embodiments the side wall may comprises a (folding) structure at an end of the side wall, wherein the (folding) structure may comprises n protruding parts; wherein the first (polymeric) enclosure extension comprises n notch elements, where the n protruding parts may be configured in the n notch elements.

As indicated above, the communication element may comprise a near field communication antenna (NFC) or a wireless communication device.

As indicated above, in embodiments the wireless communication device is further configured to communicate with a sensor. The sensor may be comprised by a device comprising the device control assembly. Alternatively or additionally, the sensor may be comprised by a system comprising the device control assembly. For instance, in embodiments the device control assembly may be comprised by a device, such as a luminaire, which may also comprise the sensor, or which may be functionally coupled to the sensor.

The term "sensor" may also refer to a plurality of (different) sensors. The sensor may in embodiments comprise one or more sensors selected from the group of an ambient light sensor (e.g. for sensing light in a space, such as a room), outdoor light sensor, temperature sensor, proximity sensor, movement sensor, etc.

The near field communication antenna may receive instructions from an external device, like an external control system and/or a user interface. This instructions may be provided to the device control electronics.

With the NFC, the driver may be configurated in production or in the application without making direct connection. Configuration can be power, dimming level, ampere level, etc.

With the wireless communication device, the driver can wireless communicate with sensors, so the driver can give the required signals to the (light generating) device.

Especially, in embodiments the device control assembly may comprise both the near field communication antenna and the wireless communication device.

In embodiments, the field communication antenna and the wireless communication device may be at least partly enclosed by a single enclosure. In other embodiments, the field communication antenna and the wireless communication device are each at least partly enclosed by a respective enclosure.

Hence, in specific embodiments the device control assembly may comprise both the near field communication antenna and the wireless communication device. Further, the (polymeric) enclosure element functionally coupled to the second support part. Especially, in embodiments the (polymeric) enclosure element may at least partly encloses both the field communication antenna and the wireless communication device. Especially, the (polymeric) enclosure element may comprise a first (polymeric) enclosure extension and optionally also a further (such as a second) (polymeric) enclosure extension. In embodiments, the (metal) closure may be configured to lock the first (polymeric) enclosure extension (and the optional further (polymeric) enclosure extensions).

Therefore, in specific (other) embodiments the (lighting) device control assembly may comprise the near field communication antenna and the wireless communication device, wherein: (a) the near field communication antenna is functionally coupled to the second support part and functionally coupled to the (lighting) device control electronics; (b) the wireless communication device is functionally coupled to the second support part and functionally coupled to the (lighting) device control electronics; wherein the wireless communication device is further configured to communicate with a sensor; (c) a primary (polymeric) enclosure element may be functionally coupled to the second support part, wherein the primary (polymeric) enclosure element may at least partly enclose the near field communication antenna, wherein the primary (polymeric) enclosure element may comprise a primary first (polymeric) enclosure extension, wherein the (metal) closure may be configured to lock the primary first (polymeric) enclosure extension (especially wherein the (metal) closure may be configured to exert a force on the primary first (polymeric) enclosure extension in a direction of the support); and (d) a secondary (polymeric) enclosure element may be functionally coupled to the second support part, wherein the secondary (polymeric) enclosure element may at least partly enclose the wireless communication device, wherein the secondary (polymeric) enclosure element may comprise a secondary first (polymeric) enclosure extension, wherein the (metal) closure may be configured to lock the secondary first (polymeric) enclosure extension (especially wherein the (metal) closure may be configured to exert a force on the secondary first (polymeric) enclosure extension in a direction of the support).

The two (or more) enclosure elements may in specific embodiments be interconnected (with an interconnection). Such interconnection may be between the two (or more) housing parts, or between the two (or more) enclosure extensions, though other options may also be possible. Such interconnection may also be indicated as bridging element. Hence, in specific embodiments the primary polymeric enclosure element and the secondary polymeric enclosure element comprise one or more bridging elements interconnecting the primary polymeric enclosure element and the secondary polymeric enclosure element.

In yet a further aspect, the device control assembly is especially configured to control one or more light sources of a light generating module. The light generating module may comprise a luminaire, or a luminaire may comprise the light generating module.

Hence, in an aspect the invention provides a light generating module comprising a light source and the lighting device control assembly as defined herein, wherein the lighting device control assembly is configured to control the light source.

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc.. Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions form a remote control. In embodiments, the control system may be controlled via an App on a device, such as a portable device, like a Smartphone or I-phone, a tablet, etc.. The device is thus not necessarily coupled to the lighting system, but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system on the basis of knowledge (input by a user interface of with an optical sensor (e.g. QR code reader) of the (unique) code. The lighting system may also comprise means for communicating with other systems or devices, such as on the basis of Bluetooth, WIFI, LiFi, ZigBee, BLE or WiMAX, or another wireless technology.

The system, or apparatus, or device may execute an action in a "mode" or "operation mode" or "mode of operation" or "operational mode". The term "operational mode may also be indicated as "controlling mode". Likewise, in a method an action or stage, or step may be executed in a "mode" or "operation mode" or "mode of operation" or "operational mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, that can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

Therefore, in embodiments the lighting device control assembly may be configured to control the light source control in dependence of one or more of an input signal of a user interface, a sensor signal (of a sensor), and a timer. As indicated above, the wireless communication device may be configured to communicate with the sensor.

In yet a further aspect, the invention also provides a light generating system comprising (i) one or more light generating modules as defined herein, and (ii) a control system wherein the control system comprises the one or more lighting device control assemblies (of the respective one or more light generating modules).

In embodiments, each module may comprise a master control system. In yet other embodiments, each module may comprise a slave control system, and the system may comprise a (single) master control system. Hence, in embodiments there may be a (master) control system controlling all lighting device control assemblies.

As indicated above, the system may comprise a sensor. Therefore, in specific embodiments the light generating system may further comprise a sensor, wherein the control system is configured to control the one or more light generating modules via their respective lighting device control assemblies, especially in embodiments in dependence of a sensor signal of the sensor. Note that other control options, such as via a user interface, may in embodiments not be excluded.

In yet a further aspect, the invention also provides a method for assembling the (lighting) device control assembly. In an aspect, the invention provides a method for assembling the ((lighting)) device control assembly as defined herein, wherein the method comprises: (A) providing: (i) the housing part, the support comprising the first support part and the second support part; (ii) the (lighting) device control electronics functionally coupled to the first support part; (iii) the communication element functionally coupled to the second support part and functionally coupled to the (lighting) device control electronics; (iv) the (polymeric) enclosure element functionally coupled to the second support part, wherein the (polymeric) enclosure element at least partly encloses the communication element, wherein the (polymeric) enclosure element comprises the first (polymeric) enclosure extension; (B) an assembly stage comprising: functionally coupling the (metal) closure to the housing part, thereby (i) providing together with the first support part the enclosure for the (lighting) device electronics (especially thereby locking the first (polymeric) enclosure extension). Yet further, in embodiments the assembly stage may comprise: functionally coupling the (metal) closure to the housing part, thereby (i) providing together with the first support part the enclosure for the (lighting) device electronics, and (ii) (thereby) exerting a force on the first polymeric enclosure extension in the direction of the support.

In yet further specific embodiments, preceding the assembly stage the method may comprise a solder bath stage, wherein the solder bath stage may comprise: exposing a second side of the support other than a first side of the communication element to a solder bath. As indicated above, this may lead to a deformation of bosses and/or click elements at or protruding from the second side.

Yet, in further specific embodiments (of the method), the metal closure may comprise (i) a first closure part configured parallel to a length axis (LA) of the support and providing a top wall of the enclosure in an assembled state, and (ii) a second closure part providing a side wall of the enclosure in the assembled state; wherein the first polymeric enclosure extension may comprise a notch element, wherein the assembly stage may comprise: functionally coupling the metal closure to the first support part. By functionally coupling the metal closure to the first support part, the enclosure extension, and thus the enclosure, may substantially be locked. Alternatively or additionally, by functionally coupling the metal closure to the first support part, also a force may be exerted on an edge of the notch element in the direction of the support.

The light generating system may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, digital projection, or LCD backlighting. The light generating system (or luminaire) may be part of or may be applied in e.g. optical communication systems or disinfection systems.

The terms "visible", "visible light" or "visible emission" and similar terms refer to light having one or more wavelengths in the range of about 380-780 nm. The terms "light" and "radiation" are herein interchangeably used, unless clear from the context that the term "light" only refers to visible light. The terms "light" and "radiation" may thus refer to UV radiation, visible light, and IR radiation. In specific embodiments, especially for lighting applications, the terms "light" and "radiation" refer to (at least) visible light.

In yet a further aspect, the invention also provides a lamp or a luminaire comprising the light generating system as defined herein. The luminaire may further comprise a housing, optical elements, louvres, etc. etc... The lamp or luminaire may further comprise a housing enclosing the light generating system. The lamp or luminaire may comprise a light window in the housing or a housing opening, through which the system light may escape from the housing.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1i schematically depict some aspects;
Figs. 2a-2b schematically depicts some embodiments;
Fig. 3 schematically depicts an embodiment and some variants; and
Fig. 4 schematically depicts an embodiment and some variants. The schematic drawings are not necessarily to scale.

### DETAILED DESCRIPTION OF THE EMBODIMENTS

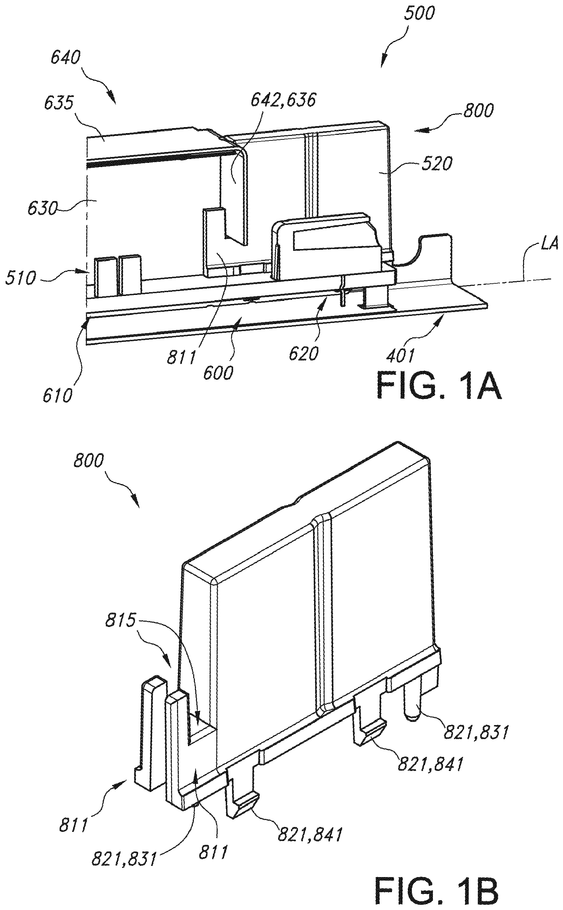

Figs. 1a-1j schematically depict some aspects of the device control assembly 500, which may be further indicated as "lighting device control assembly 500".

In embodiments, the lighting device control assembly 500 may comprise a housing part 401, a support 600, lighting device control electronics 510, a closure 640 (which may further be indicated as "metal closure 640"), communication element 520, and enclosure element 800 (which may further be indicated as "polymeric enclosure element 800").

The lighting device control electronics 510 comprises a lighting device driver.

The support 600 may comprise a printed circuit board. The support 600 may comprise a first support part 610 and a second support part 620. Especially, the support 600 may be functionally coupled to the housing part 401 (see e.g. Fig. 1a).

Especially, the lighting device control electronics 510 may be functionally coupled to the first support part 610 of the support 600.

Further, the metal closure 640 may be functionally coupled to the housing part 401. Especially, the lighting device control electronics 510 may be configured in an enclosure 630 at least partly defined by the metal closure 640 and the housing part 401.

Further, in embodiments the communication element 520 may be functionally coupled to the second support part 620 and may be functionally coupled to the lighting device control electronics 510.

The polymeric enclosure element 800 may be functionally coupled to the second support part 620. Further, the polymeric enclosure element 800 may at least partly enclose the communication element 520. Yet, in embodiments the polymeric enclosure element 800 comprises a first polymeric enclosure extension 811. Especially, the metal closure 640 may be configured to lock the first polymeric enclosure extension 811. In other words, the metal closure 640 may be configured to lock the polymeric enclosure element 800.

Further, the metal closure 640 may in specific embodiments be configured to exert a force on the first polymeric enclosure extension 811 in a direction of the support 600.

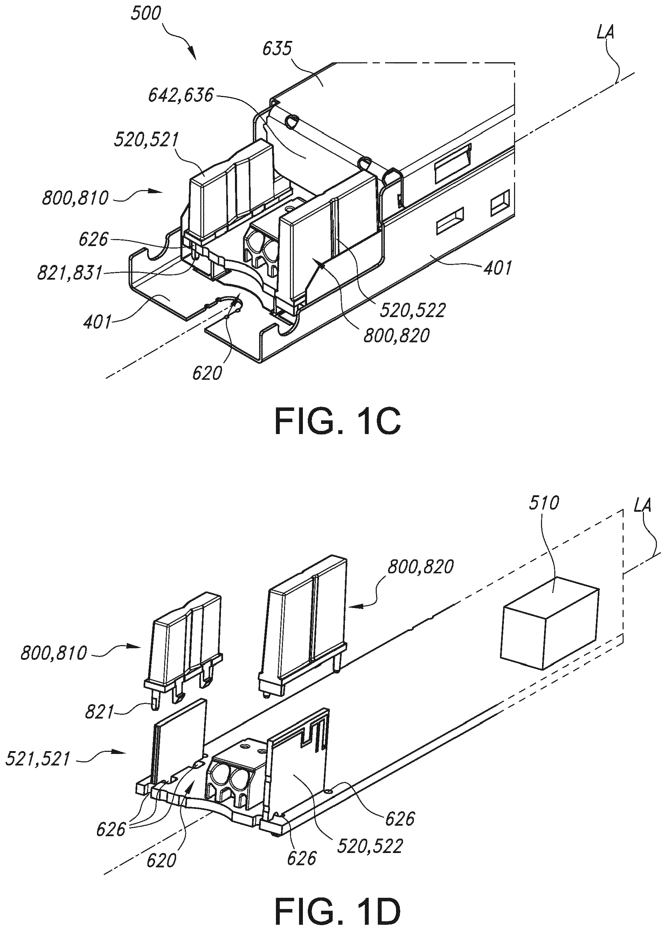

Referring to Fig. la and e.g. also Fig. 1c, the metal closure 640 may comprise (i) a first closure part 641 configured parallel to a length axis LA of the support 600 and providing a top wall 635 of the enclosure 630, and (ii) a second closure part 642 providing a side wall 636 of the enclosure 630; wherein the second closure part 642 is configured to exert the force on the first polymeric enclosure extension 811 in the direction of the support 600.

Referring to e.g. also Fig. 1b, the first polymeric enclosure extension 811 may comprise a notch element 815. Especially, in embodiments part of the metal closure 640 may be configured in the notch element 815. In specific embodiments, the metal closure 640 may be configured to exerts a force on an edge 816 of the notch element 815 in the direction of the support 600. The force may not necessary. Hence, the metal closure 640 may be configured in the notch element 815 and thereby lock the enclosure element 800.

In specific embodiments, see also Fig. 1b, the polymeric enclosure element 800 may comprise two or more (substantially parallel configured) first polymeric enclosure extensions 811, each comprising a notch element 815.

Referring to Figs. 1c-1d, the support 600 may comprise one or more support part openings 626. Further, the polymeric enclosure element 800 may comprise one or more second polymeric enclosure extensions 821 extending into the one or more support part openings 626.

In embodiments, the one or more second polymeric enclosure extensions 821 may be selected from the group of (i) bosses 831 and (ii) click connection elements 841 configured for a click connection with the respective support part openings 626.

In specific embodiments, the lighting device control assembly 500 may comprise at least one click connection element 841, wherein a part 842 of the click connection element 841 at a second side 602 of the support 600 other than a first side 601 of the communication element 520 is at least partly deformed (as a result of exposure to a solder bath). The deformation is not shown.

In embodiments, the polymeric enclosure element 800 comprises polycarbonate.

Referring also to Fig. 1d, the polymeric enclosure element 800 may enclose at least 70% of an external surface of the communication element 520.

In embodiments, the communication element 520 is selected from the group consisting of a near field communication antenna 521 and a wireless communication device 522.

Referring e.g. to Figs. 1c-1d, the lighting device control assembly 500 may comprise the near field communication antenna 521 and the wireless communication device 522. In embodiments, the near field communication antenna 521 may be functionally coupled to the second support part 620 and functionally coupled to the lighting device control electronics 510. Further, in embodiments the wireless communication device 522 may be functionally coupled to the second support part 620 and functionally coupled to the lighting device control electronics 510. Yet further, in embodiments the wireless communication device 522 may be further configured to communicate with a sensor 310.

Yet, in embodiments a primary polymeric enclosure element 810 may be functionally coupled to the second support part 620. The primary polymeric enclosure element 810 may at least partly enclose the near field communication antenna 521. The primary polymeric enclosure element 810 may comprise a primary first polymeric enclosure extension 8111. The metal closure 640 may be configured to lock the primary first polymeric enclosure extension 8111. In embodiments, the metal closure 640 may be configured to exert a force on the primary first polymeric enclosure extension 8111 in a direction of the support 600.

Yet, in embodiments a secondary polymeric enclosure element 820 may be functionally coupled to the second support part 620. The secondary polymeric enclosure element 820 may at least partly enclose the wireless communication device 522. The secondary polymeric enclosure element 820 may comprise a secondary first polymeric enclosure extension 8112. The metal closure 640 may be configured to lock the secondary first polymeric enclosure extension 8112. In embodiments, the metal closure 640 may be configured to exert a force on the secondary first polymeric enclosure extension 8112 in a direction of the support 600.

Further, referring to Fig. 1d (and other figures, like 1a, 1b, 1c, 1f, 1h and 1i), it is also schematically depicted that the enclosure element 800 may essentially entirely enclose the communication element, except for an opening part directed to the support element 600. The opening part may essentially be closed by the support element.

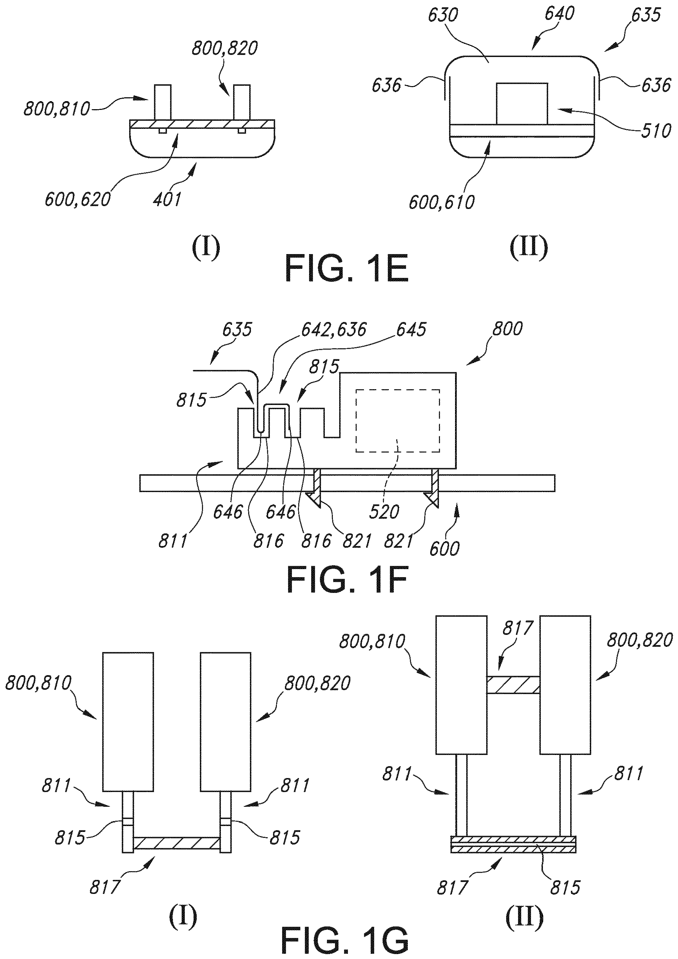

Fig. 1e provides a cross-sectional views at two position, with embodiment I showing an embodiment of a cross-section at a position of the second support part 620 and embodiment II showing an embodiment of a cross-section at a position of the first support part 610.

Referring to Fig. 1f, the side wall 636 may comprise a (folding) structure 645 at an end of the side wall 636. The (folding) structure 645 comprises n protruding parts 646. Especially, the first polymeric enclosure extension 811 comprises n notch elements 815, where the n protruding parts 646 are configured in the n notch elements 815. In the example, n=2. The number n may e.g. be selected from the range of 1-6, like 2-6, such as 2-4.

Referring to Fig. 1g, two embodiments are schematically depicted wherein the primary polymeric enclosure element 810 and the secondary polymeric enclosure element 820 comprise one or more bridging elements 817 interconnecting the primary polymeric enclosure element 810 and the secondary polymeric enclosure element 820. In embodiment II, the notch 15 is comprised in one of the bridging elements 817.

Referring to Figs. 1a-1g, the invention also provides a method for assembling a lighting device control assembly 500, wherein the method comprises: (A) providing: (i) the housing part 401, the support 600 comprising the first support part 610 and the second support part 620; (ii) the lighting device control electronics 510 functionally coupled to the first support part 610; (iii) the communication element 520 functionally coupled to the second support part 620 and functionally coupled to the lighting device control electronics 510; (iv) the polymeric enclosure element 800 functionally coupled to the second support part 620, wherein the polymeric enclosure element 800 at least partly encloses the communication element 520, wherein the polymeric enclosure element 800 comprises the first polymeric enclosure extension 811; and (B) an assembly stage comprising: functionally coupling the metal closure 640 to the housing part 401, thereby (i) providing together with the first support part 610 the enclosure 630 for the lighting device control electronics 510 (thereby locking the first polymeric enclosure extension 811). This method may in specific embodiments comprise ) providing together with the first support part 610 the enclosure 630 for the lighting device control electronics 510 and exerting the force on the first polymeric enclosure extension 811 in the direction of the support 600 (thereby locking the first polymeric enclosure extension 811).

In specific embodiments, preceding the assembly stage the method may comprise a solder bath stage, wherein the solder bath stage may comprise: exposing a second side 602 of the support 600 other than a first side 601 of the communication element 520 to a solder bath.

Further, in specific embodiments (of the method) the metal closure 640 may comprise (i) a first closure part 641 configured parallel to a length axis LA of the support 600 and providing a top wall 635 of the enclosure 630 in an assembled state, and (ii) a second closure part 642 providing a side wall 636 of the enclosure 630 in the assembled state; wherein the first polymeric enclosure extension 811 comprises a notch element 815, wherein the assembly stage comprises: functionally coupling the metal closure 640 to the first support part 610, thereby optionally exerting a force on an edge 816 of the notch element 815 in the direction of the support 600.

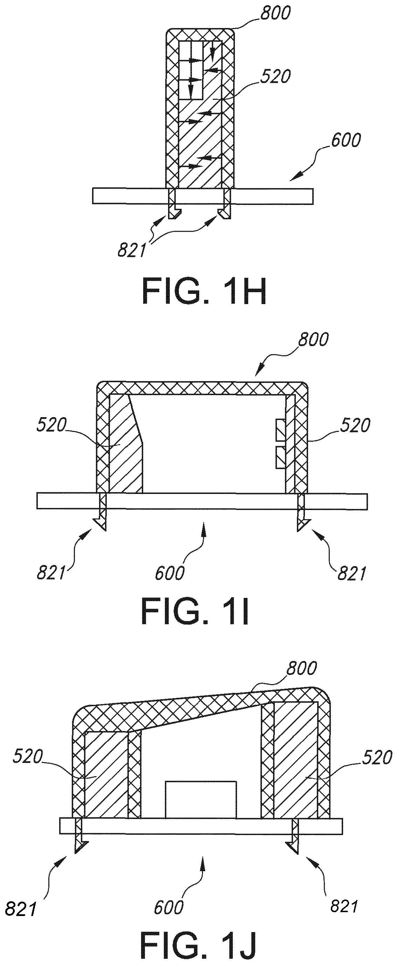

Fig. 1h schematically depicts that the percentage of enclosure can be defined by using the smallest cuboid enclosing the enclosure element and the communication element 520, and integrating the are from which a normal of the cuboid intersects the enclosure element. This is schematically depicted with the arrows. Note that from the support 600 in a direction to the communication element 520, arrows perpendicular to the support would reach the communication element without intercepting the enclosure element 800. Hence, in general the enclosing percentage is lower than 100%, as there may be substantially no enclosure element material between the communication element and the support.

Fig. 1i schematically depicts a single enclosure 800 enclosing two communication elements 520, such as the near field communication antenna and the wireless communication device. By way of example, herein the communication devices 520 are not depicted with schematic cuboids.

Fig. 1j also schematically depicts a single enclosure 800 enclosing two communication elements 520, such as the near field communication antenna and the wireless communication device. Here, by way of example the communication devices 520 are again schematically depicted as cuboids. Further, by way of example another component may be configured between the two communication elements 520. Hence, the enclosure 800 may define a further cavity, for other elements which are not necessarily included in the cavity or cavities for hosting the communication element(s) 520.

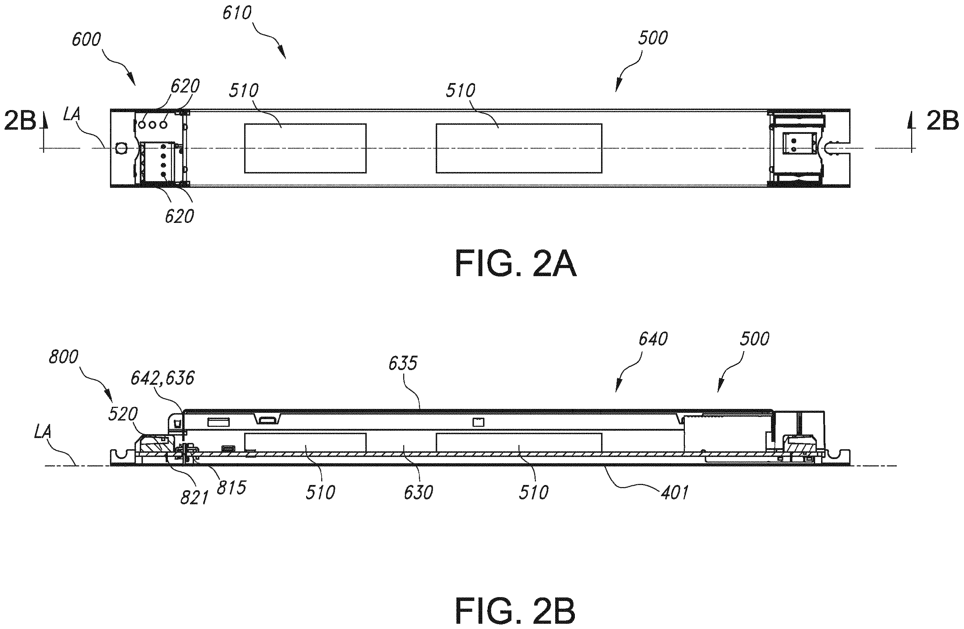

Figs. 2a-2b schematically depict 2 views of embodiments of the module 500.

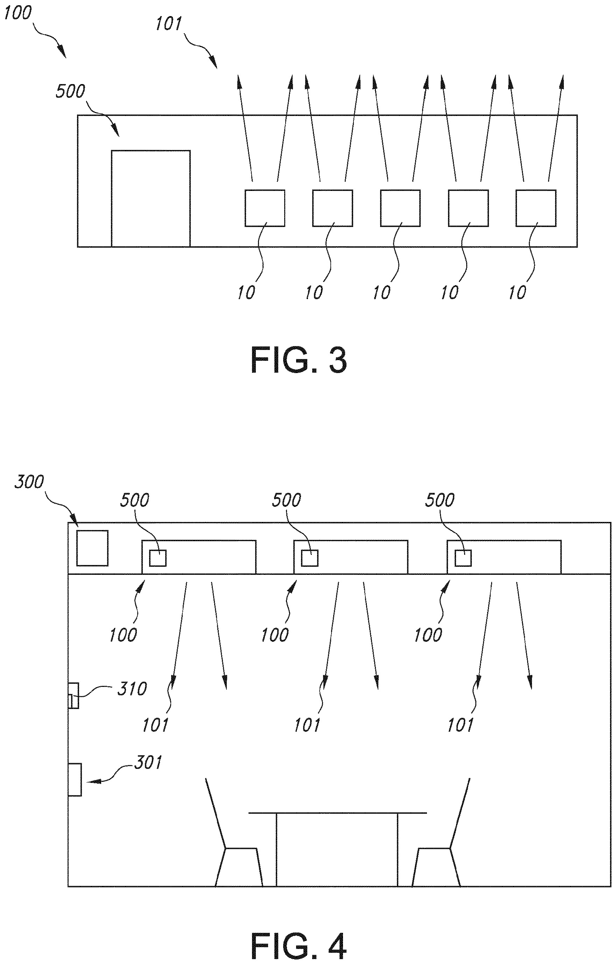

Fig. 3 schematically depicts an embodiment of a light generating module 100 comprising a light source 10 and the lighting device control assembly 500 as defined herein, wherein the lighting device control assembly 500 is configured to control the light source 10.

Fig. 4 schematically depicts an embodiments of a light generating system 1000 comprising (i) one or more light generating modules 100, and (ii) a control system 300 wherein the control system 300 comprises the one or more lighting device control assemblies 500. Reference 301 refers to a user interface and reference 310 refers to a sensor.

In specific embodiments, the light generating system 1000 may (thus) further comprising a sensor 310. Especially, in such embodiments the control system 300 may be configured to control the one or more light generating modules 100 via their respective lighting device control assemblies 500 in dependence of a sensor signal of the sensor 310.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" also includes embodiments wherein the term "comprises" means "consists of'.

The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage. In yet a further aspect, the invention (thus) provides a software product, which, when running on a computer is capable of bringing about (one or more embodiments of) the method as described herein.

The invention also provides a control system that may control the device, apparatus, or system, or that may execute the herein described method or process. Yet further, the invention also provides a computer program product, when running on a computer which is functionally coupled to or comprised by the device, apparatus, or system, controls one or more controllable elements of such device, apparatus, or system.

The invention further applies to a device, apparatus, or system comprising one or more of the characterizing features described in the description and/or shown in the attached drawings. The invention further pertains to a method or process comprising one or more of the characterizing features described in the description and/or shown in the attached drawings.

The various aspects discussed in this patent can be combined in order to provide additional advantages. Further, the person skilled in the art will understand that embodiments can be combined, and that also more than two embodiments can be combined. Furthermore, some of the features can form the basis for one or more divisional applications.

## Claims

1. A lighting device control assembly (500) comprising:
- a housing part (401);
- a support (600) comprising a printed circuit board, wherein the support (600) comprises a first support part (610) and a second support part (620); wherein the support (600) is functionally coupled to the housing part (401);
- lighting device control electronics (510) functionally coupled to the first support part (610) of the support (600);
- a closure (640) functionally coupled to the housing part (401), wherein the lighting device control electronics (510) are configured in an enclosure (630) at least partly defined by the closure (640) and the housing part (401);
- a communication element (520) functionally coupled to the second support part (620) and functionally coupled to the lighting device control electronics (510);
- a polymeric enclosure element (800) functionally coupled to the second support part (620), wherein the polymeric enclosure element (800) at least partly encloses the communication element (520), wherein the polymeric enclosure element (800) comprises a first polymeric enclosure extension (811), wherein the closure (640) is configured to lock the first polymeric enclosure extension (811).

2. The lighting device control assembly (500) according to claim 1, wherein the lighting device control electronics (510) comprises a lighting device driver; wherein the polymeric enclosure element (800) encloses at least 70% of an external surface of the communication element (520); and wherein the closure (640) is configured to exert a force on the first polymeric enclosure extension (811) in a direction of the support (600).

3. The lighting device control assembly (500) according to any one of the preceding claims, wherein the first polymeric enclosure extension (811) comprises a notch element (815), wherein part of the closure (640) is configured in the notch element (815) and exerts a force on an edge (816) of the notch element (815) in the direction of the support (600).

4. The lighting device control assembly (500) according to any one of the preceding claims, wherein the support (600) comprises one or more support part openings (626), wherein the polymeric enclosure element (800) comprises one or more second polymeric enclosure extensions (821) extending into the one or more support part openings (626).

5. The lighting device control assembly (500) according to claim 4, wherein the one or more second polymeric enclosure extensions (821) are selected from the group of (i) bosses (831) and (ii) click connection elements (841) configured for a click connection with the respective support part openings (626).

6. The lighting device control assembly (500) according to any one of the preceding claims, wherein the polymeric enclosure element (800) comprises polycarbonate.

7. The lighting device control assembly (500) according to any one of the preceding claims, wherein the closure (640) comprises (i) a first closure part (641) configured parallel to a length axis (LA) of the support (600) and providing a top wall (635) of the enclosure (630), and (ii) a second closure part (642) providing a side wall (636) of the enclosure (630); wherein the second closure part (642) is configured to exert the force on the first polymeric enclosure extension (811) in the direction of the support (600).

8. The lighting device control assembly (500) according to any one of the preceding claims, wherein the communication element (520) is selected from the group consisting of a near field communication antenna (521) and a wireless communication device (522).

9. The lighting device control assembly (500) according to claim 8, comprising the near field communication antenna (521) and the wireless communication device (522), wherein:
- the near field communication antenna (521) is functionally coupled to the second support part (620) and functionally coupled to the lighting device control electronics (510);
- the wireless communication device (522) is functionally coupled to the second support part (620) and functionally coupled to the lighting device control electronics (510); wherein the wireless communication device (522) is further configured to communicate with a sensor (310);
- a primary polymeric enclosure element (810) is functionally coupled to the second support part (620), wherein the primary polymeric enclosure element (810) at least partly encloses the near field communication antenna (521), wherein the primary polymeric enclosure element (810) comprises a primary first polymeric enclosure extension (8111), wherein the closure (640) is configured to lock the primary first polymeric enclosure extension (8111); and
- a secondary polymeric enclosure element (820) is functionally coupled to the second support part (620), wherein the secondary polymeric enclosure element (820) at least partly encloses the wireless communication device (522), wherein the secondary polymeric enclosure element (820) comprises a secondary first polymeric enclosure extension (8112), wherein the closure (640) is configured to lock the secondary first polymeric enclosure extension (8112).

10. A light generating module (100) comprising a light source (10) and the lighting device control assembly (500) according to any one of the preceding claims, wherein the lighting device control assembly (500) is configured to control the light source (10).

11. A light generating system (1000) comprising (i) one or more light generating modules (100) according to claim 10, and (ii) a control system (300) wherein the control system (300) comprises the one or more lighting device control assemblies (500).

12. The light generating system (1000) according to claim 11, further comprising a sensor (310), wherein the control system (300) is configured to control the one or more light generating modules (100) via their respective lighting device control assemblies (500) in dependence of a sensor signal of the sensor (310).

13. A method for assembling a lighting device control assembly (500) according to any one of the preceding claims 1-9, the method comprising:
- providing:
(i) the housing part (401), the support (600) comprising the first support part (610) and the second support part (620);
(ii) the lighting device control electronics (510) functionally coupled to the first support part (610);
(iii) the communication element (520) functionally coupled to the second support part (620) and functionally coupled to the lighting device control electronics (510);
(iv) the polymeric enclosure element (800) functionally coupled to the second support part (620), wherein the polymeric enclosure element (800) at least partly encloses the communication element (520), wherein the polymeric enclosure element (800) comprises the first polymeric enclosure extension (811);
- an assembly stage comprising: functionally coupling the closure (640) to the housing part (401), thereby (i) providing together with the first support part (610) the enclosure (630) for the lighting device control electronics (510).

14. The method according to claim 13, wherein preceding the assembly stage the method comprises a solder bath stage, wherein the solder bath stage comprises: exposing a second side (602) of the support (600) other than a first side (601) of the communication element (520) to a solder bath.

15. The method according to any one of the preceding claims 13-14, wherein the closure (640) comprises (i) a first closure part (641) configured parallel to a length axis (LA) of the support (600) and providing a top wall (635) of the enclosure (630) in an assembled state, and (ii) a second closure part (642) providing a side wall (636) of the enclosure (630) in the assembled state; wherein the first polymeric enclosure extension (811) comprises a notch element (815), wherein the assembly stage comprises: functionally coupling the closure (640) to the first support part (610), thereby exerting a force on an edge (816) of the notch element (815) in the direction of the support (600).

## Patentansprüche

1. Beleuchtungsvorrichtungssteueranordnung (500), umfassend:
- ein Gehäuseteil (401);
- einen Träger (600), umfassend eine Leiterplatte, wobei der Träger (600) einen ersten Trägerteil (610) und einen zweiten Trägerteil (620) umfasst; wobei der Träger (600) mit dem Gehäuseteil (401) funktional gekoppelt ist;
- Beleuchtungsvorrichtungssteuerelektronik (510), die mit dem ersten Trägerteil (610) des Trägers (600) funktional gekoppelt ist;
- einen Verschluss (640), der mit dem Gehäuseteil (401) funktional gekoppelt ist, wobei die Beleuchtungsvorrichtungssteuerelektronik (510) in einer Umhüllung (630) konfiguriert ist, die mindestens teilweise durch den Verschluss (640) und das Gehäuseteil (401) definiert ist;
- ein Kommunikationselement (520), das mit dem zweiten Trägerteil (620) funktional gekoppelt ist und mit der Beleuchtungsvorrichtungssteuerelektronik (510) funktional gekoppelt ist;
- ein polymeres Umhüllungselement (800), das mit dem zweiten Trägerteil (620) funktional gekoppelt ist, wobei das polymere Umhüllungselement (800) das Kommunikationselement (520) mindestens teilweise umhüllt, wobei das polymere Umhüllungselement (800) eine erste polymere Umhüllungserweiterung (811) umfasst, wobei der Verschluss (640) konfiguriert ist, um die erste polymere Umhüllungserweiterung (811) zu verriegeln.

2. Beleuchtungsvorrichtungssteueranordnung (500) nach Anspruch 1, wobei die Beleuchtungsvorrichtungssteuerelektronik (510) einen Beleuchtungsvorrichtungstreiber umfasst; wobei das polymere Umhüllungselement (800) mindestens 70 % einer Außenoberfläche des Kommunikationselements (520) umhüllt; und wobei der Verschluss (640) konfiguriert ist, um eine Kraft auf die erste polymere Umhüllungserweiterung (811) in einer Richtung des Trägers (600) auszuüben.

3. Beleuchtungsvorrichtungssteueranordnung (500) nach einem der vorstehenden Ansprüche, wobei die erste polymere Umhüllungserweiterung (811) ein Kerbelement (815) umfasst, wobei ein Teil des Verschlusses (640) in dem Kerbelement (815) konfiguriert ist und eine Kraft auf eine Kante (816) des Kerbelements (815) in der Richtung des Trägers (600) ausübt.

4. Beleuchtungsvorrichtungssteueranordnung (500) nach einem der vorstehenden Ansprüche, wobei der Träger (600) eine oder mehrere Trägerteilöffnungen (626) umfasst, wobei das polymere Umhüllungselement (800) eine oder mehrere zweite polymere Umhüllungserweiterungen (821) umfasst, die sich in die eine oder die mehreren Trägerteilöffnungen (626) erweitern.

5. Beleuchtungsvorrichtungssteueranordnung (500) nach Anspruch 4, wobei die eine oder die mehreren zweiten polymeren Umhüllungserweiterungen (821) aus der Gruppe von (i) Vorsprüngen (831) und (ii) Klickverbindungselementen (841) ausgewählt sind, die für eine Klickverbindung mit den jeweiligen Trägerteilöffnungen (626) konfiguriert sind.

6. Beleuchtungsvorrichtungssteueranordnung (500) nach einem der vorstehenden Ansprüche, wobei das polymere Umhüllungselement (800) Polycarbonat umfasst.

7. Beleuchtungsvorrichtungssteueranordnung (500) nach einem der vorstehenden Ansprüche, wobei der Verschluss (640) (i) ein erstes Verschlussteil (641), das parallel zu einer Längenachse (LA) des Trägers (600) konfiguriert ist und eine obere Wand (635) der Umhüllung (630) bereitstellt, und (ii) ein zweites Verschlussteil (642) umfasst, das eine Seitenwand (636) der Umhüllung (630) bereitstellt; wobei das zweite Verschlussteil (642) konfiguriert ist, um die Kraft auf die erste polymere Umhüllungserweiterung (811) in der Richtung des Trägers (600) auszuüben.

8. Beleuchtungsvorrichtungssteueranordnung (500) nach einem der vorstehenden Ansprüche, wobei das Kommunikationselement (520) aus der Gruppe ausgewählt ist, die aus einer Nahfeldkommunikationsantenne (521) und einer Drahtloskommunikationsvorrichtung (522) besteht.

9. Beleuchtungsvorrichtungssteueranordnung (500) nach Anspruch 8, umfassend die Nahfeldkommunikationsantenne (521) und die Drahtloskommunikationsvorrichtung (522), wobei:
- die Nahfeldkommunikationsantenne (521) mit dem zweiten Trägerteil (620) funktional gekoppelt und mit der Beleuchtungsvorrichtungssteuerelektronik (510) funktional gekoppelt ist;
- die Drahtloskommunikationsvorrichtung (522) mit dem zweiten Trägerteil (620) funktional gekoppelt und mit der Beleuchtungsvorrichtungssteuerelektronik (510) funktional gekoppelt ist; wobei die Drahtloskommunikationsvorrichtung (522) ferner konfiguriert ist, um mit einem Sensor (310) zu kommunizieren;
- ein primäres polymeres Umhüllungselement (810) mit dem zweiten Trägerteil (620) funktional gekoppelt ist, wobei das primäre polymere Umhüllungselement (810) die Nahfeldkommunikationsantenne (521) mindestens teilweise umhüllt, wobei das primäre polymere Umhüllungselement (810) eine primäre erste polymere Umhüllungserweiterung (8111) umfasst, wobei der Verschluss (640) konfiguriert ist, um die primäre erste polymere Umhüllungserweiterung (8111) zu verriegeln; und
- ein sekundäres polymeres Umhüllungselement (820) mit dem zweiten Trägerteil (620) funktional gekoppelt ist, wobei das sekundäre polymere Umhüllungselement (820) die Drahtloskommunikationsvorrichtung (522) mindestens teilweise umhüllt, wobei das sekundäre polymere Umhüllungselement (820) eine sekundäre erste polymere Umhüllungserweiterung (8112) umfasst, wobei der Verschluss (640) konfiguriert ist, um die sekundäre erste polymere Umhüllungserweiterung (8112) zu verriegeln.

10. Lichterzeugungsmodul (100), umfassend eine Lichtquelle (10) und die Beleuchtungsvorrichtungssteueranordnung (500) nach einem der vorstehenden Ansprüche, wobei die Beleuchtungsvorrichtungssteueranordnung (500) konfiguriert ist, um die Lichtquelle (10) zu steuern.

11. Lichterzeugungssystem (1000), umfassend (i) ein oder mehrere Lichterzeugungsmodule (100) nach Anspruch 10 und (ii) ein Steuersystem (300), wobei das Steuersystem (300) die eine oder die mehreren Beleuchtungsvorrichtungssteueranordnungen (500) umfasst.

12. Lichterzeugungssystem (1000) nach Anspruch 11, ferner umfassend einen Sensor (310), wobei das Steuersystem (300) konfiguriert ist, um das eine oder die mehreren Lichterzeugungsmodule (100) über ihre jeweiligen Beleuchtungsvorrichtungssteueranordnungen (500) in Abhängigkeit von einem Sensorsignal des Sensors (310) zu steuern.

13. Verfahren zum Montieren einer Beleuchtungsvorrichtungssteueranordnung (500) nach einem der vorstehenden Ansprüche 1 bis 9, das Verfahren umfassend:
- Bereitstellen:
(i) des Gehäuseteils (401), des Trägers (600), umfassend das erste Trägerteil (610) und das zweite Trägerteil (620);
(ii) der Beleuchtungsvorrichtungssteuerelektronik (510), die mit dem ersten Trägerteil (610) funktional gekoppelt ist;
(iii) des Kommunikationselements (520), das mit dem zweiten Trägerteil (620) funktional gekoppelt und mit der Beleuchtungsvorrichtungssteuerelektronik (510) funktional gekoppelt ist;
(iv) des polymeren Umhüllungselements (800), das mit dem zweiten Trägerteil (620) funktional gekoppelt ist, wobei das polymere Umhüllungselement (800) das Kommunikationselement (520) mindestens teilweise umhüllt, wobei das polymere Umhüllungselement (800) die erste polymere Umhüllungserweiterung (811) umfasst;
- einen Montageschritt, umfassend: funktionales Koppeln des Verschlusses (640) mit dem Gehäuseteil (401), wodurch (i) zusammen mit dem ersten Trägerteil (610) die Umhüllung (630) für die Beleuchtungsvorrichtungssteuerelektronik (510) bereitgestellt wird.

14. Verfahren nach Anspruch 13, wobei das Verfahren vor der Montagephase eine Lötbadphase umfasst, wobei die Lötbadphase umfasst: Aussetzen einer zweiten Seite (602) des Trägers (600) mit Ausnahme einer ersten Seite (601) des Kommunikationselements (520) einem Lötbad.

15. Verfahren nach einem der vorstehenden Ansprüche 13 bis 14, wobei der Verschluss (640) (i) ein erstes Verschlussteil (641), das parallel zu einer Längenachse (LA) des Trägers (600) konfiguriert ist und in einem montierten Zustand eine obere Wand (635) der Umhüllung (630) bereitstellt, und (ii) ein zweites Verschlussteil (642) umfasst, das in dem montierten Zustand eine Seitenwand (636) der Umhüllung (630) bereitstellt; wobei die erste polymere Umhüllungserweiterung (811) ein Kerbelement (815) umfasst, wobei die Montagephase umfasst: funktionales Koppeln des Verschlusses (640) mit dem ersten Trägerteil (610), wodurch eine Kraft auf eine Kante (816) des Kerbelements (815) in der Richtung des Trägers (600) ausgeübt wird.

## Revendications

1. Ensemble de commande de dispositif d'éclairage (500) comprenant :
- une partie boîtier (401) ;
- un support (600) comprenant une carte de circuit imprimé, dans lequel le support (600) comprend une première partie de support (610) et une seconde partie de support (620) ; dans lequel le support (600) est accouplé fonctionnellement à la partie boîtier (401) ;
- une électronique de commande de dispositif d'éclairage (510) accouplée fonctionnellement à la première partie de support (610) du support (600) ;
- une fermeture (640) accouplée fonctionnellement à la partie boîtier (401), dans lequel l'électronique de commande de dispositif d'éclairage (510) est configurée dans une enceinte (630) définie au moins en partie par la fermeture (640) et la partie boîtier (401) ;
- un élément de communication (520) accouplé fonctionnellement à la seconde partie de support (620) et accouplé fonctionnellement à l'électronique de commande de dispositif d'éclairage (510) ;
- un élément d'enceinte polymère (800) accouplé fonctionnellement à la seconde partie de support (620), dans lequel l'élément d'enceinte polymère (800) entoure au moins en partie l'élément de communication (520), dans lequel l'élément d'enceinte polymère (800) comprend une première extension d'enceinte polymère (811), dans lequel la fermeture (640) est conçue pour verrouiller la première extension d'enceinte polymère (811).

2. Ensemble de commande de dispositif d'éclairage (500) selon la revendication 1, dans lequel l'électronique de commande de dispositif d'éclairage (510) comprend un pilote de dispositif d'éclairage ; dans lequel l'élément d'enceinte polymère (800) entoure au moins 70 % d'une surface externe de l'élément de communication (520) ; et dans lequel la fermeture (640) est conçue pour exercer une force sur la première extension d'enceinte polymère (811) dans une direction du support (600).

3. Ensemble de commande de dispositif d'éclairage (500) selon l'une quelconque des revendications précédentes, dans lequel la première extension d'enceinte polymère (811) comprend un élément d'encoche (815), dans lequel une partie de la fermeture (640) est conçue dans l'élément d'encoche (815) et exerce une force sur un bord (816) de l'élément d'encoche (815) dans la direction du support (600).

4. Ensemble de commande de dispositif d'éclairage (500) selon l'une quelconque des revendications précédentes, dans lequel le support (600) comprend une ou plusieurs ouvertures de partie de support (626), dans lequel l'élément d'enceinte polymère (800) comprend une ou plusieurs secondes extensions d'enceinte polymères (821) s'étendant dans la ou les ouvertures de partie de support (626).

5. Ensemble de commande de dispositif d'éclairage (500) selon la revendication 4, dans lequel la ou les secondes extensions d'enceinte polymères (821) sont choisies dans le groupe constitué de (i) bossages (831) et (ii) d'éléments de connexion par clic (841) configurés pour une connexion par clic avec les ouvertures de partie de support respectives (626).

6. Ensemble de commande de dispositif d'éclairage (500) selon l'une quelconque des revendications précédentes, dans lequel l'élément d'enceinte polymère (800) comprend du polycarbonate.

7. Ensemble de commande de dispositif d'éclairage (500) selon l'une quelconque des revendications précédentes, dans lequel la fermeture (640) comprend (i) une première partie de fermeture (641) configurée parallèlement à un axe de longueur (LA) du support (600) et fournissant une paroi supérieure (635) de l'enceinte (630), et (ii) une seconde partie de fermeture (642) fournissant une paroi latérale (636) de l'enceinte (630) ; dans lequel la seconde partie de fermeture (642) est configurée pour exercer la force sur la première extension d'enceinte polymère (811) dans la direction du support (600).

8. Ensemble de commande de dispositif d'éclairage (500) selon l'une quelconque des revendications précédentes, dans lequel l'élément de communication (520) est choisi dans le groupe constitué d'une antenne de communication en champ proche (521) et d'un dispositif de communication sans fil (522).

9. Ensemble de commande de dispositif d'éclairage (500) selon la revendication 8, comprenant l'antenne de communication en champ proche (521) et le dispositif de communication sans fil (522), dans lequel :
- l'antenne de communication en champ proche (521) est accouplée fonctionnellement à la seconde partie de support (620) et accouplée fonctionnellement à l'électronique de commande de dispositif d'éclairage (510) ;
- le dispositif de communication sans fil (522) est accouplé fonctionnellement à la seconde partie de support (620) et accouplé fonctionnellement à l'électronique de commande de dispositif d'éclairage (510) ; dans lequel le dispositif de communication sans fil (522) est en outre configuré pour communiquer avec un capteur (310) ;
- un élément d'enceinte polymère principal (810) est accouplé fonctionnellement à la seconde partie de support (620), dans lequel l'élément d'enceinte polymère principal (810) entoure au moins en partie l'antenne de communication en champ proche (521), dans lequel l'élément d'enceinte polymère principal (810) comprend une première extension d'enceinte polymère principale (8111), dans lequel la fermeture (640) est configurée pour verrouiller la première extension d'enceinte polymère principale (8111) ; et
- un élément d'enceinte polymère secondaire (820) est accouplé fonctionnellement à la seconde partie de support (620), dans lequel l'élément d'enceinte polymère secondaire (820) entoure au moins en partie le dispositif de communication sans fil (522), dans lequel l'élément d'enceinte polymère secondaire (820) comprend une première extension d'enceinte polymère secondaire (8112), dans lequel la fermeture (640) est configurée pour verrouiller la première extension d'enceinte polymère secondaire (8112).

10. Module de génération de lumière (100) comprenant une source de lumière (10) et l'ensemble de commande de dispositif d'éclairage (500) selon l'une quelconque des revendications précédentes, dans lequel l'ensemble de commande de dispositif d'éclairage (500) est configuré pour commander la source de lumière (10).

11. Système de génération de lumière (1000) comprenant (i) un ou plusieurs modules de génération de lumière (100) selon la revendication 10, et (ii) un système de commande (300), dans lequel le système de commande (300) comprend le ou les ensembles de commande de dispositif d'éclairage (500).

12. Système de génération de lumière (1000) selon la revendication 11, comprenant en outre un capteur (310), dans lequel le système de commande (300) est configuré pour commander le ou les modules de génération de lumière (100) par l'intermédiaire de leurs ensembles de commande de dispositif d'éclairage respectifs (500) en fonction d'un signal de capteur du capteur (310).

13. Procédé d'assemblage d'un ensemble de commande de dispositif d'éclairage (500) selon l'une quelconque des revendications précédentes 1 à 9, le procédé comprenant :
- la fourniture de :
(i) la partie boîtier (401), le support (600) comprenant la première partie de support (610) et la seconde partie de support (620) ;
(ii) l'électronique de commande de dispositif d'éclairage (510) accouplée fonctionnellement à la première partie de support (610) ;
(iii) l'élément de communication (520) accouplé fonctionnellement à la seconde partie de support (620) et accouplé fonctionnellement à l'électronique de commande de dispositif d'éclairage (510) ;
(iv) l'élément d'enceinte polymère (800) accouplé fonctionnellement à la seconde partie de support (620), dans lequel l'élément d'enceinte polymère (800) entoure au moins en partie l'élément de communication (520), dans lequel l'élément d'enceinte polymère (800) comprend la première extension d'enceinte polymère (811) ;
- une étape d'assemblage comprenant : l'accouplement fonctionnel de la fermeture (640) à la partie boîtier (401), (i) fournissant ainsi avec la première partie de support (610) l'enceinte (630) pour l'électronique de commande de dispositif d'éclairage (510).

14. Procédé selon la revendication 13, dans lequel, avant l'étape d'assemblage, le procédé comprend une étape de bain de soudure, dans lequel l'étape de bain de soudure comprend : l'exposition d'un second côté (602) du support (600) autre qu'un premier côté (601) de l'élément de communication (520) à un bain de soudure.

15. Procédé selon l'une quelconque des revendications précédentes 13 et 14, dans lequel la fermeture (640) comprend (i) une première partie de fermeture (641) configurée parallèlement à un axe de longueur (LA) du support (600) et fournissant une paroi supérieure (635) de l'enceinte (630) dans un état assemblé, et (ii) une seconde partie de fermeture (642) fournissant une paroi latérale (636) de l'enceinte (630) dans l'état assemblé ; dans lequel la première extension d'enceinte polymère (811) comprend un élément d'encoche (815), dans lequel l'étape d'assemblage comprend : l'accouplement fonctionnel de la fermeture (640) à la première partie de support (610), exerçant ainsi une force sur un bord (816) de l'élément d'encoche (815) dans la direction du support (600).
